# EUROPÄISCHE PATENTSCHRIFT

(11) **EP 4 032 125 B1**
(45) Veröffentlichungstag und Bekanntmachung des Hinweises auf die Patenterteilung: **17.12.2025**
(21) Anmeldenummer: 20775573.7
(22) Anmeldetag: 12.09.2020
(51) Int. Cl.: H10K 50/858, H10K 59/38

(54) **OLED-WELLENLEITERANORDNUNG SOWIE HERSTELLUNGSVERFAHREN DAZU**
OLED-WAVEGUIDE ASSEMBLY AND PRODUCTION METHOD THERFOR
ENSEMBLE GUIDE-D'ONDES À OLED ET PROCÉDÉ DE PRODUCTION CORRESPONDANT

(30) Priorität: 17.09.2019 DE 102019124950
(43) Veröffentlichungstag der Anmeldung: 27.07.2022
(73) Patentinhaber: Christian-Albrechts-Universität zu Kiel, 24118 Kiel (DE)
(72) Erfinder: GERKEN, Martina, 24116 Kiel (DE); BUHL, Janek, 24118 Kiel (DE); BREMER, Matthias, 93047 Regensburg (DE); HEIN, Sabrina, 24793 Bargstedt (DE)
(86) Internationale Anmeldenummer: PCT/DE2020/100796
(87) Internationale Veröffentlichungsnummer: WO 2021/052532

(56) Entgegenhaltungen:
- EP-A1- 0 878 883
- JP-A- 2013 191 464
- US-A1- 2010 054 291

## Beschreibung

Die Erfindung betrifft eine OLED-Wellenleiter-Anordnung (1) mit einer organischen Leuchtdiodenanordnung (11), einer Wellenleiterschicht (13) und einem Substrat (14), wobei die organische Leuchtdiodenanordnung (11) durch eine Abstandsschicht (12) von der Wellenleiterschicht getrennt ist und die organische Leuchtdiodenanordnung (11), die Abstandsschicht (12), die Wellenleiterschicht (13) und das Substrat (14) stofflich miteinander in einem Schichtenstapel verbunden sind und die Emission der organischen Leuchtdiodenanordnung (11) bei einer Wellenlänge um 470 Nanometer maximale Emission aufweist.

Ferner betrifft die Erfindung ein OLED-Wellenleiter-Anordnungsherstellungsverfahren für eine entsprechende erfindungsgemäße OLED-Wellenleiter-Anordnung.

Die organische Leuchtdiodenanordnung/OLED ist durch eine Abstandsschicht von der lumineszierenden Schicht getrennt. Die Wellenleiterschicht ist nanostrukturiert ausgebildet und besteht entweder selbst aus lumineszierendem Material oder weist eine vorgelagerte Schicht aus lumineszierendem Material auf. Das lichtemittierende Material in dem lumineszierenden Teil der Wellenleiterschicht wird durch die Strahlung aus der organischen Leuchtdiodenanordnung optisch angeregt. Die Nanostruktur der Wellenleiterschicht dient der gerichteten Abstrahlung.

OLEDs mit einer gerichteten Abstrahlcharakteristik haben ein großes Potenzial für die Realisierung von kostengünstigen, integrierten Lichtquellen z. B. für die Biosensorik oder für schaltbare Oberflächeneigenschaften.

Weiterhin ermöglicht eine gerichtete Emission autostereoskopische Displays mit hoher Auflösung und bietet für die Datenübertragung mit sichtbarem Licht (engl. visible light communication, VLC) neue Ansätze.

Aus dem **Stand der Technik** ist eine Anordnung bekannt, in der eine OLED über einen Schichtenstapel mit einer Lumineszenzschicht verbunden ist, nämlich in der Druckschrift US 2009/0051271 A1 ist eine OLED mit transparenter Elektrode beschrieben, die zusätzlich mit einer Lumineszenzschicht bedeckt wird. Die Lumineszenzschicht wird hierbei als Wellenlängenkonverter verwendet, so dass die Auskopplungseffizienz einer OLED verbessert werden kann.

Die Druckschrift WO 2017/053855 A1 offenbart einen Apparat zur Lichtbeugung und eine organische Leuchtdiode (OLED), die den Lichtbeugungsapparat enthält. Eine Vorrichtung zur Lichtbeugung kann eine optionale Planarisierungsschicht, ein transparentes Substrat und eine Wellenleiterschicht umfassen. Die Planarisierungsschicht kann einen Brechungsindex von ns haben. Das transparente Substrat weist einen Brechungsindex von ng auf. Die Wellenleiterschicht, die über das transparente Substrat verteilt ist, kann einen Brechungsindex nw haben, der größer als ns und größer als nw ist. Die Wellenleiterschicht kann aus einer Bindematrix und mindestens einem Nanopartikel bestehen. Die Wellenleiterschicht kann zwischen dem transparenten Substrat und der optionalen Planarisierungsschicht eingefügt werden.

In der Druckschrift US 2018/0047944 A1 wird ein emittierender Artikel, enthaltend eine OLED mit einer Lichtemissionsoberfläche, einen Zirkularpolarisator und einen Lichtextraktionsfilm, der optisch zwischen der OLED und dem Zirkularpolarisator liegt und optisch an die Lichtemissionsoberfläche gekoppelt ist, beschrieben. Der Lichtextraktionsfilm enthält eine zweidimensional strukturierte Schicht aus Extraktionselementen mit einem ersten Brechungsindex und einem Abstand in einem Bereich von 400 bis 800 nm und eine Hinterfüllschicht, die ein Material mit einem zweiten Brechungsindex enthält, der sich von dem ersten Brechungsindex unterscheidet.

Die Druckschrift US 2009/0015142 A1 offenbart einen multifunktionalen optischen Film zur Verbesserung der Lichtextraktion, ein flexibles Substrat, eine strukturierte Schicht und eine Hinterfüllschicht. Die strukturierte Schicht verwendet effektiv mikroreplizierte diffraktive oder streuende Nanostrukturen, die nahe genug an der lichterzeugenden Region liegen, um die Extraktion einer evaneszenten Welle aus einem organischen Leuchtdioden-Bauelement (OLED) zu ermöglichen. Die Hinterfüllschicht hat ein Material mit einem anderen Brechungsindex als der Brechungsindex der strukturierten Schicht. Die Hinterfüllschicht bietet auch eine planarisierende Schicht über der strukturierten Schicht, um den Lichtextraktionsfilm an eine Schicht einer OLED-Anzeigevorrichtung anzupassen. Der Film kann zusätzliche Schichten haben, die zu einer emittierenden Oberfläche hinzugefügt oder in diese integriert werden, um zusätzliche Funktionalitäten über die Verbesserung der Lichtextraktionseffizienz hinaus zu bewirken.

In der Druckschrift US 2017/0301888 A1 werden neuartige lichtemittierende Bauelemente, einschließlich AMOLED-Displays, die auf einer transparenten OLED-Architektur basieren, bei der eine laminierte nanostrukturierte Lichtauskopplungsfolie axiale und integrierte optische Verstärkungen sowie verbesserte Winkel-Lumina und Farben erzeugen kann, offenbart. Zu den transparenten AMOLED-Displays mit laminierten Submikron-Extraktoren gehören im Allgemeinen: (a) ein Extraktor auf einem transparenten Substrat zur Lichtauskopplung auf beiden Seiten der transparenten Vorrichtung; oder (b) ein Extraktor auf einem reflektierenden Film zur Bereitstellung einer Lichtauskopplung von der Unterseite der unten emittierenden (BE) AMOLED; oder (c) ein Extraktor auf einem lichtabsorbierenden Film zur Bereitstellung einer Auskopplung von der Unterseite der BE AMOLED in Kombination mit einem verbesserten Umgebungskontrast.

Die Druckschrift EP 0 878 883 A1 offenbart einen organischen Laser umfassend eine elektrisch gepumpte Quelle für inkohärente Strahlung mit einem organischen aktiven Bereich und ferner eine Wellenleiterstruktur, die die inkohärente Strahlung empfängt. Der Kern des Wellenleiters besteht aus organischem Material, das die inkohärente Strahlung absorbiert und kohärente Strahlung längerer Wellenlänge emittiert. Die Quelle der inkohärenten Strahlung befindet sich in der Nähe des Wellenleiterkerns, z. B. in einem Abstand von weniger als 10 lambda vom Kern, wobei lambda die Laserwellenlänge ist. Der Laser ist zum Beispiel in einem planaren Wellenleiterlaser, in einem Mikroscheibenlaser oder in einem Laser mit photonischer Bandlückenstruktur realisiert.

Aus der Druckschrift US 2010/054291 A1 ist eine kleine und leichte organische Laservorrichtung, die auf reproduzierbare Weise hergestellt werden kann und aus der Laserlicht mit einer gewünschten Wellenlänge erhalten werden kann, bekannt. Ein erstes Substrat, das mit einem lichtemittierenden Element mit einer lichtemittierenden Schicht zwischen einem Elektrodenpaar versehen ist, und ein zweites Substrat, das mit einem Lasermedium versehen ist, das einen Laserfarbstoff enthält, liegen einander gegenüber, und eine Elektrode des Elektrodenpaars, das zwischen der lichtemittierenden Schicht und dem Lasermedium angeordnet ist, hat eine lichtdurchlässige Eigenschaft. Mit einer solchen Struktur kann eine Laservorrichtung bereitgestellt werden, in der ein Lasermedium und eine Lichtquelle integriert sind.

**Ein Problem im Stand der Technik** ist im Wesentlichen, dass es bisher keine technische Lösung gibt, um hochgradig gerichtete Emission aus OLED-Lichtquellen zu erhalten. Hierzu wurde insbesondere bisher die Integration von Nanostrukturen in OLEDs zur Erzeugung von gerichteter Strahlung untersucht. Die Nanostruktur koppelt dabei geführte Moden gerichtet aus. Dieses dient gleichzeitig der Erhöhung der Leistungseffizienz. Nachteilig ist dabei, dass die ungerichtete Emission der OLED sich mit der gerichteten Emission überlagert. Da beide in demselben Wellenlängenbereich liegen, können sie nicht getrennt werden. Weiterhin verhindert die Absorption der OLED-Schichten hohe Gütefaktoren und damit schmale Abstrahlcharakteristika. Die Nutzung eines schmalbandigen Emitters erlaubt es, den Anteil an gerichteter Emission zu erhöhen. Dieses ist jedoch beschränkt auf bestimmte Emittermaterialien und geht zu Lasten der Effizienz. Als Alternative wurde auch die Kopplung einer OLED mit einem diffraktiven optischen Element (DOE) vorgeschlagen, um sowohl hochgradig gerichtete Emission zu erreichen als auch durch das DOE die Abstrahlcharakteristik entwerfen zu können, wobei dieser Ansatz jedoch nicht die direkte gerichtete Abstrahlung eines OLED-Pixels ermöglicht, sondern zusätzliche Fläche erfordert. In einem weiteren Ansatz wird die Kombination von zwei übereinanderliegenden OLEDs vorgeschlagen, um die Abstrahlcharakteristik einzustellen und auch zeitlich verändern zu können. Dieses bringt einen komplexeren Aufbau mit sich und es wurde noch keine hochgradig gerichtete Emission demonstriert.

Aus dem **Stand der Technik** ist gemäß den vorher gewürdigten Druckschriften keine OLED-Wellenleiteranordnung bekannt, bei der organische Strukturen zur Bildung der Abstandsschicht und der Wellenleiterschicht genutzt werden und eine Gitterstruktur passend zur Wellenlänge des Sekundärlichts, aber nicht passend zu der Wellenlänge des Primärlichts angewendet wird.

Der vorliegenden Erfindung liegt die **Aufgabe** zugrunde, eine OLED-Wellenleiteranordnung und ein dazugehöriges Herstellungsverfahren anzugeben, wodurch die OLED-Wellenleiteranordnung insbesondere eine hochgradig gerichtete Abstrahlcharakteristik aufweisen soll.

**Gelöst** wird diese Aufgabe mit einer OLED-Wellenleiteranordnung gemäß Hauptanspruch sowie einem OLED-Wellenleiter-Anordnungsherstellungsverfahren für eine OLED-Wellenleiter-Anordnung gemäß nebengeordnetem Anspruch.

Die OLED-Wellenleiter-Anordnung ist mit einer organischen Leuchtdiodenanordnung, einer Wellenleiterschicht und einem Substrat ausgebildet, wobei
- die organische Leuchtdiodenanordnung durch eine Abstandsschicht von der Wellenleiterschicht getrennt ist
   und
- die organische Leuchtdiodenanordnung, die Abstandsschicht, die Wellenleiterschicht und das Substrat stofflich miteinander in einem Schichtenstapel verbunden sind
   und
- die Emission der organischen Leuchtdiodenanordnung bei einer Wellenlänge um 470 Nanometer maximale Emission aufweist,
wobei
- die Wellenleiterschicht nanostrukturiert ausgebildet ist,
- die Wellenleiterschicht und die Abstandsschicht aus organischem Material gebildet sind
- die Abstandsschicht für das Licht aus der organischen Leuchtdiodenanordnung und das Licht aus der Wellenleiterschicht transparent ausgebildet ist,
- die organische Leuchtdiodenanordnung als Primärlichtquelle ausgebildet ist,
- das Substrat pixelabhängige, nämlich pixelweise identische oder pixelweise leicht unterschiedliche, Nanostrukturen auf der Oberfläche aufweist, die mit einer Gitterkonstante von ungefähr 400 ± 50 Nanometer passend zu den Emissionen der Wellenleiterschicht ausgebildet sind,
- die Abstandsschicht eine Schichtdicke von 300 bis 500 Nanometer aufweist,
wobei
- die Wellenleiterschicht
   - selbst aus lumineszierendem Material besteht
      oder
   - eine vorgelagerte Schicht aus lumineszierendem Material aufweist,
- die Wellenleiterschicht oder die vorgelagerte Schicht des Wellenleiters die Funktion eines Wellenlängenkonverters mit maximaler Absorption um 470 Nanometer und mit maximaler Emission um 620 Nanometer aufweist,
   und
- das Substrat wenigstens die Außenseite der Anordnung auf der Lichtaustrittsfläche ist oder
- das Substrat wenigstens die Außenseite der Anordnung auf der Lichtaustrittsfläche ist, wobei eine zusätzliche wellenlängenselektive (dichroitische) Schicht und/oder ein Langpassfilter auf der Lichtaustrittsfläche in den Schichtstapel integriert ist.

In der erfindungsgemäßen OLED-Wellenleiteranordnung wird von einer OLED ein Primärlicht erzeugt, welches nachfolgend in eine 300 bis 500 Nanometer beabstandete Wellenleiterschicht mit Lumineszenz gelangt, wo es in ein Lumineszenzlicht (Sekundärlicht) generiert. Die Abstandsschicht ist sowohl für die OLED als auch für die Wellenleiterschicht transparent und dient der Vermeidung der Reabsorption des Sekundärlichts durch die OLED. Die Wellenleiterschicht ist periodisch so strukturiert, dass sie eine enge Abstrahlcharakteristik für das Sekundärlicht besitzt. Das Primärlicht weist eine Wellenlänge von ungefähr 470 Nanometer auf und das Sekundärlicht eine Wellenlänge von ungefähr 620 Nanometern. Die Gitterkonstante liegt bei 400 +/- 50 Nanometer und ist somit nicht für das Primärlicht geeignet.

Die Nutzung einer Gitterstruktur, die nicht zur Emission der verbauten OLED passt, ist neuartig und erfinderisch. Idealerweise wird sämtliches Primärlicht konvertiert oder Reste hiervon werden herausgefiltert. Es erfolgt eine gerichtete Abstrahlung des Sekundärlichts mit einer Wellenlänge von 620 Nanometer. Zudem können sowohl OLED als auch Wellenleiterschicht und Abstandsschicht aus organischem Material gebildet werden.

Die OLED-Wellenleiter-Anordnung besteht erfindungsgemäß alternativ in einer Variante aus einer organischen Leuchtdiodenanordnung, einer Wellenleiterschicht und einem Substrat, wobei die Schichten stofflich miteinander in einem Schichtenstapel verbunden sind, wobei die organische Leuchtdiodenanordnung durch eine Abstandsschicht von der lumineszierenden Schicht getrennt ist, die Wellenleiterschicht nanostrukturiert ausgebildet ist und die Wellenleiterschicht selbst aus lumineszierendem Material besteht oder eine vorgelagerte Schicht aus lumineszierendem Material aufweist.

Die Wellenleiterschicht kann in einer bevorzugten Ausgestaltung die Nanostrukturierung wenigstens auf der zum Substrat hingewandten Seite aufweisen.

Die Wellenleiterschicht kann bevorzugt vollständig nanostrukturiert ausgebildet sein.

Wenn die vorgelagerte Schicht aus lumineszierendem Material besteht, dann übernimmt diese die Funktion des Wellenlängenkonverters.

Die Nanostrukturen auf Wellenleiterschicht können insbesondere pixelweise ausgelegt werden, wobei die Nanostrukturen auf der Wellenleiterschicht pixelweise identisch oder pixelweise leicht unterschiedlich sein können.

Die organische Leuchtdiodenanordnung dient als Primärlichtquelle und kann in Form dünner, teiltransparenter Metallschichten und/oder leitfähiger Polymere und/oder Poly-3,4-ethylendioxythiopen und/oder Polystyrolsulfonat mit Kohlenstoffnanoröhren ausgelegt sein.

Weiter kann bevorzugt der Brechungsindex der Wellenleiterschicht höher ausgebildet sein als der von Substrat und Abstandsschicht.

Das lumineszierende Material der Wellenleiterschicht kann bevorzugt eine Schichtdicke aufweisen, bei der das Primärlicht nahezu vollständig absorbiert wird.

Die Wellenleiterschicht und / oder Abstandsschicht sind bevorzugt gebildet aus:
- (2-{(E)-2-[4-(Dimethylamino)phenyl]vinyl}-6-methyl-4H-pyran-4-yliden)malononitril zur Dotierung in Polyvinylcarbazol
   und /oder
- Tris-(4,7-diphenyl-1,10-phenanthropon)-ruthenium (II) Dichlorid in Polymethylmethacrylat und / oder
- Super Yellow als Polymer ohne separate Matrix.

Ferner sei an dieser Stelle nachfolgend ergänzend zum Stand der Technik ausgeführt, dass das Erzeugen von OLED's mit Emmisionsmaximum bei ca -470nm allgemeines fachmännisches Können ist, nämlich bekannt aus bspw.:
- Kim, Tae-Gu, Oh, Hwan Sool, Kim, You-Hyun, and 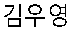 , "Study of Deep Blue Organic Light-Emitting Diodes Using Doped BCzVBi with Various Blue Host Materials," Transactions on Electrical and Electronic Materials, vol. 11, no. 2, pp. 85-88, Apr. 2010.
- Jian Liu, Minhua Jiang, Xiaoying Zhou, Changjun Zhan, Jin Bai, Min Xiong, Fenfen Li and Yuhua Liu, "High-efficient sky-blue and green emissive OLEDs based on Flrpic and Flrdfpic", Synthetic Metals, vol. 234, pp. 111-116, 2017.
- Etienne Baranoff and Basile F. E. Curchod, "Flrpic: archetypal blue phosphorescent emitter for electroluminescence", Dalton Trans., vol. 44, no. 18, pp. 8318-8329, 2015.
- Ping-I Shih, Chen-Han Chien, Chu-Ying Chuang, Ching-Fong Shu, Cheng-Han Yang, Jian-Hong Chen and Yun, "Novel host material for highly efficient blue phosphorescent OLEDs", vol. 17, no. 17, pp. 1692-1698, 2007.
- Salehi, A., Dong, C., Shin, D. et al., "Realization of high-efficiency fluorescent organic light-emitting diodes with low driving voltage", Nat. Commun., vol. 10, 2019.
- Lee, J.-I., Lee, J., Lee, J.-W., Cho, D.-H., Shin, J.-W., Han, J.-H. and Chu, H.Y. (2012), Dependence of Light-Emitting Characteristics of Blue Phosphorescent Organic Light-Emitting Diodes on Electron Injection and Transport Materials. ETRI Journal, 34: 690-695.

Das OLED-Wellenleiter-Anordnungsherstellungsverfahren für eine erfindungsgemäße, wenn auch nur spezielle OLED-Wellenleiter-Anordnung weist bevorzugt die Schritte auf:
- Herstellen eines Substrats mit einer pixelabhängigen Nanostruktur auf der Oberfläche
   - im Spritzgussverfahren in Kunststoff
      oder
   - durch Aufbringen einer Photolackschicht auf dem Substrat und Strukturierung mit Hilfe eines Nanoprägeverfahrens;
- Aufbringen einer Wellenleiterschicht enthaltend eine Photolumineszenzschicht durch Flüssigphasenbeschichtung oder Verdampfung oder Kathodenzerstäubung, wobei entweder ein Material beide Zwecke erfüllen kann oder zwei separate Materialien verwendet werden;
- Aufbringen einer Abstandsschicht, die die aktiven Schichten der organischen Leuchtdiodenanordnung von dem nanostrukturierten Wellenleiter trennt;
- Prozessieren der organischen Leuchtdiodenanordnung oberhalb der Abstandschicht aus der Flüssigphase und/oder in einem Vakuumprozess.

Im Detail bedeutet dies:
Auslegen einer unteren Elektrode der organischen Leuchtdiodenanordnung in teiltransparenter Weise und Aufbringen von organischen Transport-, Block- und Emissionsschichten auf die teiltransparente Elektrode, wobei die organische Leuchtdiodenanordnung mit einer zweiten Metallelektrode ausgestaltet wird, die bevorzugt dicker und nichttransparent ausgebildet sein kann, und wobei ein Versiegeln der Oberseite der organischen Leuchtdiodenanordnung, also der der Emission der Strahlung abgewandten Seite, bevorzugt mit einer Verkapselung aus Glas oder Kunststoff erfolgt.

Durch das Versiegeln der OLED-Wellenleiter-Anordnung mit einer Verkapselung aus Glas oder Kunststoff kann insbesondere eine Degradation durch Luftsauerstoff von der Oberseite vermieden werden.

Durch den Schichtenaufbau der OLED-Wellenleiteranordnung ist das übliche Verfahren der Herstellung der organischen Leuchtdiodenanordnung mit durch Kathodenzerstäubung aufgebrachtem Indiumzinnoxid nicht geeignet.

Die Emission der Leuchtdiodenanordnung sollte insbesondere von der Wellenlänge her zu der Absorption der Photolumineszenzschicht passen.

Die Abstandsschicht trennt die aktiven Schichten der organischen Leuchtdiodenanordnung von der nanostrukturierten Wellenleiterschicht. Je nach Brechungsindex dieser Schicht sollte die Schichtdicke so groß gewählt werden, dass das evaneszente Licht aus der Wellenleiterschicht auf einen kleinen Bruchteil (bspw. <1%) abgeklungen ist. Typischerweise handelt es sich um Schichtdicken von ca. 300 - 500 nm. Die Abstandsschicht sollte sowohl für das Lumineszenzlicht als auch das Licht aus der organischen Leuchtdiodenanordnung transparent sein.

Die Wellenleiterschicht ist insbesondere nanostrukturiert ausgebildet und kann entweder selber aus lumineszierendem Material bestehen oder kann eine vorgelagerte Schicht aus lumineszierendem Material aufweisen.

Die lumineszierende Schicht hat die Funktion eines Wellenlängenkonverters. Je nach Aufbringungsverfahren auf das Substrat kann die Wellenleiterschicht die Nanostruktur nur auf der dem Substrat zugewandten Unterseite aufweisen oder kann vollständig nanostrukturiert ausgebildet sein. Der Brechungsindex der Wellenleiterschicht sollte höher sein als der von Substrat und Abstandsschicht.

Das Substrat kann aus Kunststoff oder Glas bestehen und pixelabhängige Nanostrukturen auf der Oberfläche aufweisen. Die Nanostrukturen können hierbei pixelweise identisch oder leicht unterschiedlich ausgebildet sein. Das Substrat kann wenigstens die Außenseite der Anordnung auf der Lichtaustrittsfläche darstellen und so die organische Leuchtdiodenanordnung vor mechanischer Berührung oder auch Sauerstoffeinfluss von der Unterseite schützen.

Es besteht die Möglichkeit, die gesamte Schichtstruktur auf dem nanostrukturierten Substrat in Flüssigphasenprozessen herzustellen. Somit ist ein hohes Potential für eine kostengünstige Rolle-zu-Rolle-Herstellung gegeben.

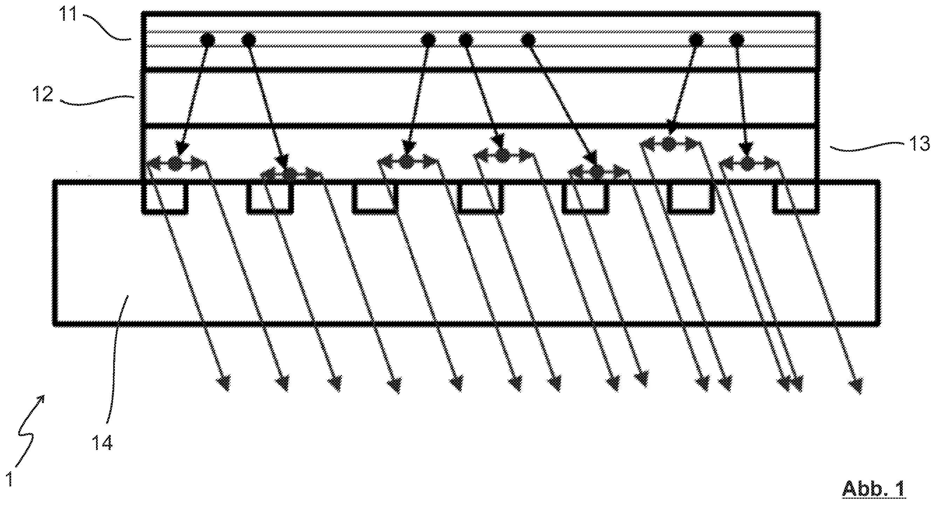

Nachfolgend werden weitere Ausführungen und Varianten der Erfindung erläutert, wobei diese nicht zwingend beschränkend zu werten sind:
Sowohl für Anwendungen in der Biosensorik als auch für Displays ist insbesondere eine Konfiguration vorzuziehen, in der das gerichtete Licht durch das Substrat emittiert wird, wie es in Abbildung 1 gezeigt ist. Das Substrat stellt dabei die Außenseite der Anordnung mit einer wohldefinierten Abstrahlcharakteristik dar und schützt die organische Leuchtdiodenanordnung/OLED vor Berührung, Flüssigkeiten in einem Mikrofluidikchip bzw. vor mechanischer Belastung bei Display-Berührung. Gleichzeitig schützt es die organische Leuchtdiodenanordnung/OLED vor Sauerstoffeinfluss von der Unterseite.

Für ein integriertes Messsystem sollen mehrere Pixel wie in Abbildung 1 gezeigt nebeneinander angeordnet werden. Die Nanostruktur soll dabei pixelweise so ausgelegt sein, dass der gewünschte Detektionsbereich im Messsystem mit der gerichteten Abstrahlung beleuchtet wird. Für ein 3D Display sollen ebenfalls Pixel mit leicht unterschiedlichen Nanostrukturen nebeneinanderliegen. Durch die Änderung der Periode wird der Abstrahlwinkel leicht verändert, was für ein autostereoskopisches Display nutzbar ist. Hier könnte im Biosensorik-Fall entsprechend ausgebildet sein, dass Pixel von verschiedenen Seiten z.B. zu einem Detektionsbereich hinleuchten. Direkt unter dem Detektionsbereich könnte dann ein Photodetektor liegen. Um die entsprechende Richtung zu erhalten, würde man Gitterstrukturen gegeneinander verdrehen. Alternativ könnte man auch eine zweidimensionale Nanostruktur wie ein zweidimensionales DOE hernehmen, um eine Strahlfokussierung in einem bestimmten Punkt zu erreichen. Für autostereoskopische Displays müssen die dabei üblichen Winkel realisiert werden.

Für eine Massenfertigung kann das Substrat mit den pixelabhängigen Oberflächennanostrukturen im Spritzgussverfahren in Kunststoff hergestellt werden.

Die Nanostruktur liegt bei Pixeln im 10 µm bis 5 mm Bereich, mit typischerweise ~500 µm.

Für Prototypen und auch Kleinserien könnte eine Photolackschicht auf dem Substrat (Glas oder Kunststoff) mit Hilfe des Nanoprägeverfahrens strukturiert werden, wobei Gitterkonstanten bzw. Gitterperioden im Bereich von 400 nm ± 50 nm (abhängig vom Wellenleiter) für die Photolumineszenz-Emission passen, wobei dies auch sehr günstig im Rolle-zu-Rolle-Verfahren möglich ist. Die periodische Nanostruktur soll hiernach Gitterkonstanten bzw. Gitterperioden passend zum Sekundärlicht aufweisen.

Weiter werden eine Wellenleiterschicht und eine Photolumineszenzschicht aufgebracht. Entweder kann ein Material beide Zwecke erfüllen oder es werden zwei separate Materialien verwendet. Die separate oder mit der Lumineszenz kombinierte Wellenleiterschicht sollte einen Brechungsindex höher als das Substrat und die Abstandsschicht haben.

Die Wellenleiterschicht kann z.B. durch Flüssigphasenbeschichtung, durch Verdampfung oder Kathodenzerstäubung auf das nanostrukturierte Substrat aufgebracht werden. Bei einer Flüssigphasenbeschichtung ist davon auszugehen, dass nur die Unterseite durch das Substrat nanostrukturiert ist, während die Oberseite durch den Beschichtungsprozess planarisiert wird.

Bei einem Aufdampfprozess bleibt die Nanostruktur typischerweise durch den Wellenleiter hindurch erhalten. Diese Wellenleiterschicht kann direkt als Matrixschicht für ein photolumineszentes Material dienen.

Alternativ kann die Wellenleiterschicht mit einer Photolumineszenzschicht beschichtet werden.

Die Absorption der Schicht für das OLED-Licht sollte bevorzugt nahezu 100% betragen. Die Photolumineszenzschicht-Schicht könnte bzw. sollte bevorzugt immer ausreichend dick ausgelegt werden, um das Primärlicht vollständig zu absorbieren.

Wellenleiter- bzw. Photolumineszenschicht und die Abstandsschicht können aus organischem Material (Polymeren) gebildet sein. Dies bedeutet, dass das organisches Material der Lumineszenzschicht organische Farbstoffe beinhalten kann.

Materialbeispiele sind DCM zur Dotierung in PVK oder Ru (ddp) in PMMA oder SuperYellow als Polymer ohne separate Matrix - DCM: 4-(Dicyanomethylene)-2-methyl-6-(4-dimethylaminostyryl)-4H-pyran (engl.) bzw. (2-{(E)-2-[4-(Dimethylamino)phenyl]vinyl}-6-methyl-4H-pyran-4-yliden)malononitril (dt.).

Alternativ weist das Photolumineszenzmaterial eine hohe Stokes-Verschiebung auf, um Anrege- und Emissionslicht sauber trennen zu können. Hierzu wird ein Langpassfilter auf der Substratunterseite platziert. Der Langpassfilter kann am kostengünstigsten als flächige Folie realisiert werden. Oder das Substrat absorbiert direkt die Anregewellenlänge.

In beiden Fällen folgt als nächste Schicht eine Abstandsschicht, bspw. aus Amonil mit n~1,5 oder PMMA mit n~1,5, die die aktiven Schichten der OLED von dem nanostrukturierten Wellenleiter trennt. Je nach Brechungsindex dieser Schicht muss die Schichtdicke so groß gewählt werden, dass das evaneszente Licht aus dem Wellenleiter auf einen kleinen Bruchteil (z.B. <1%) abgeklungen ist. Typischerweise werden hier Schichtdicken von ca. 300 - 500 nm zum Einsatz kommen. Diese Schicht müsste sowohl für das Photolumineszenzlicht als auch für das OLED Anregungslicht bevorzugt transparent sein. Diese Schicht kann ebenfalls aus der Flüssigphase hergestellt oder in einem Vakuumprozess beschichtet werden.

Oberhalb der Abstandsschicht kann die OLED aus der Flüssigphase, in einem Vakuumprozess oder in einer Kombination aus beidem prozessiert werden. Dabei muss bzw. soll besonders bevorzugt die untere Elektrode teiltransparent ausgelegt werden. Aufgrund der darunterliegenden Schichten ist das typischerweise durch Kathodenzerstäubung aufgebrachte Indiumzinnoxid (ITO) hier nicht geeignet. Bei der ITO-Beschichtung durch Kathodenzerstäubung entstehen üblicherweise hohe Temperaturen auf dem Substrat (≥ 100°C). Da die Glasübergangstemperatur vieler organischer Halbleiter tiefer liegt, könnte die ITO-Beschichtung die Morphologie der darunter liegenden Schichten und damit deren Funktionsweise negativ beeinflussen. Weiterhin wird bei einem reaktiven Beschichtungsprozess Sauerstoffgas eingeleitet, welches zu einer Oxidation der darunterliegenden organischen Schichten führen kann. Stattdessen sollen dünne, teiltransparente Metallschichten bzw. leitfähige Polymere, wie z.B. PEDOT:PSS (Poly-3,4-ethylendioxythiophen: Polystyrolsulfonat) mit Kohlenstoffnanoröhren zum Einsatz kommen. Auf die teiltransparente Elektrode können dann die organischen Transport-, Block- und Emissionsschichten aufgebracht werden. Die Emission der OLED sollte von der Wellenlänge her zu der Absorption der Photolumineszenzschicht passen, beispielsweise Max. OLED Emission bei -470 nm, Max. Absoprtion des Fluoreszenzfarbstoffes bei ∼ 470 nm, Max. Photolumineszenzemission bei -620 nm. Die konkreten Wellenlängen der Emissionsmaxima können insbesondere passend zur Gitterperiode bzw. Gitterkonstanten gewählt werden.

Abgeschlossen wird die OLED mit einer zweiten Metallelektrode, die dicker und nichttransparent sein kann. Um eine Degradation des Bauelementes durch Luftsauerstoff von der Oberseite zu vermeiden, wird es mit einer Verkapselung aus Glas oder Kunststoff versiegelt. Da die Emission durch das Substrat erfolgt, stellen sich hierbei keine besonderen Anforderungen an die Verkapselungsmaterialien.

Die gesamte Schichtstruktur kann auf dem nanostrukturierten Substrat in Flüssigphasenprozessen hergestellt werden. Damit bietet sie ein hohes Potenzial für eine kostengünstige Rolle-zu-Rolle-Herstellung.

Nachfolgend wird ein Ausführungsbeispiel der Erfindung anhand der beiliegenden Zeichnung in der **Abbildungsbeschreibung** beschrieben, wobei diese die Erfindung erläutern soll und nicht beschränkend zu werten ist.

In **Abb. 1** ist eine erfindungsgemäße OLED-Wellenleiteranordnung 1 dargestellt.

Die Vorteile der OLED-Wellenleiteranordnung liegen in einer verbesserten Auskopplungseffienz durch die Kombination einer organischen Leuchtdiodenanordnung 11 mit einer eine Photolumineszenzschicht enthaltenden Wellenleiterschicht 13 sowie einer definierten Abstrahlcharakteristik durch eine nanostrukturierte Wellenleiterschicht 13.

Die OLED-Wellenleiteranordnung 1 ist in einem Schichtenstapel aufgebaut. Von oben nach unten zeigt die Abbildung eine organische Leuchtdiodenanordnung 11, eine Abstandsschicht 12, eine Wellenleiterschicht 13 und ein Substrat 14.

Die organische Leuchtdiodenanordnung 11 dient als Primärlichtquelle.

Die Abstandsschicht 12 trennt die aktiven Schichten der organischen Leuchtdiodenanordnung 11 von der nanostrukturierten Wellenleiterschicht 13. Die Abstandsschicht 12 ist sowohl für das Lumineszenzlicht als auch das Licht aus der organischen Leuchtdiodenanordnung 11 transparent.

Die Wellenleiterschicht 13 ist nanostrukturiert ausgebildet und besteht entweder selber aus lumineszierendem Material oder hat eine vorgelagerte Schicht aus lumineszierendem Material. Die lumineszierende Schicht hat die Funktion eines Wellenlängenkonverters. Der

Brechungsindex der Wellenleiterschicht 13 ist höher als der von Substrat 14 und Abstandsschicht 12.

Das Substrat 14 besteht aus Kunststoff oder Glas und hat pixelabhängige Nanostrukturen auf der Oberfläche. Es stellt wenigstens die Außenseite der Anordnung auf der Lichtaustrittsfläche dar und schützt die organische Leuchtdiodenanordnung vor mechanischer Berührung oder auch Sauerstoffeinfluss von der Unterseite.

### Bezugszeichenliste

- 1: OLED-Wellenleiter-Anordnung
- 11: organische Leuchtdiodenanordnung
- 12: Abstandsschicht
- 13: Wellenleiterschicht
- 14: Substrat

## Patentansprüche

1. OLED-Wellenleiter-Anordnung (1) mit einer organischen Leuchtdiodenanordnung (11), einer Wellenleiterschicht (13) und einem Substrat (14), wobei
- die organische Leuchtdiodenanordnung (11) durch eine Abstandsschicht (12) von der Wellenleiterschicht getrennt ist
und
- die organische Leuchtdiodenanordnung (11), die Abstandsschicht (12), die Wellenleiterschicht (13) und das Substrat (14) stofflich miteinander in einem Schichtenstapel verbunden sind
und
- die Emission der organischen Leuchtdiodenanordnung (11) bei einer Wellenlänge um 470 Nanometer maximale Emission aufweist,
**dadurch gekennzeichnet, dass**
- die Wellenleiterschicht (13) nanostrukturiert ausgebildet ist,
- die Wellenleiterschicht (13) und die Abstandsschicht (12) aus organischem Material gebildet sind
- die Abstandsschicht (12) für das Licht aus der organischen Leuchtdiodenanordnung (11) und das Licht aus der Wellenleiterschicht (13) transparent ausgebildet ist,
- die organische Leuchtdiodenanordnung (11) als Primärlichtquelle ausgebildet ist,
- das Substrat (14) pixelabhängige, nämlich pixelweise identische oder pixelweise leicht unterschiedliche, Nanostrukturen auf der Oberfläche aufweist, die mit einer Gitterkonstante von ungefähr 400 ± 50 Nanometer passend zu den Emissionen der Wellenleiterschicht (13) ausgebildet sind,
- die Abstandsschicht (12) eine Schichtdicke von 300 bis 500 Nanometer aufweist, wobei
- die Wellenleiterschicht (13)
- selbst aus lumineszierendem Material besteht
oder
- eine vorgelagerte Schicht aus lumineszierendem Material aufweist,
- die Wellenleiterschicht (13) oder die vorgelagerte Schicht des Wellenleiters die Funktion eines Wellenlängenkonverters mit maximaler Absorption um 470 Nanometer und mit maximaler Emission um 620 Nanometer aufweist
und
- das Substrat (14) wenigstens die Außenseite der Anordnung auf der Lichtaustrittsfläche ist
oder
- das Substrat (14) wenigstens die Außenseite der Anordnung auf der Lichtaustrittsfläche ist, wobei eine zusätzliche wellenlängenselektive (dichroitische) Schicht und/oder ein Langpassfilter auf der Lichtaustrittsfläche in den Schichtstapel integriert ist.

2. OLED-Wellenleiter-Anordnung (1) nach Anspruch 1,
**dadurch gekennzeichnet, dass**
die Wellenleiterschicht (13) vollständig nanostrukturiert ausgebildet ist.

3. OLED-Wellenleiter-Anordnung (1) nach Anspruch 1 oder 2,
**dadurch gekennzeichnet, dass**
die Wellenleiterschicht (13) die Nanostrukturierung wenigstens auf der zum Substrat (14) hingewandten Seite aufweist.

4. OLED-Wellenleiter-Anordnung (1) nach einem der vorangehenden Ansprüche,
**dadurch gekennzeichnet, dass**
die Nanostrukturen auf Wellenleiterschicht (13) pixelweise ausgelegt sind, wobei die Nanostrukturen auf der Wellenleiterschicht (13)
- pixelweise identisch
oder
- pixelweise leicht unterschiedlich
sind.

5. OLED-Wellenleiter-Anordnung (1) nach einem der vorangehenden Ansprüche,
**dadurch gekennzeichnet, dass**
der Brechungsindex der Wellenleiterschicht (13) höher ist als der von Substrat (14) und Abstandsschicht (12).

6. OLED-Wellenleiter-Anordnung (1) nach einem der vorangehenden Ansprüche,
**dadurch gekennzeichnet, dass**
die organische Leuchtdiodenanordnung (11) in Form dünner, teiltransparenter Metallschichten und/oder leitfähige Polymerer und/oder Poly-3,4-ethylendioxythiopen und/oder Polystyrolsulfonat mit Kohlenstoffnanoröhren ausgelegt ist.

7. OLED-Wellenleiter-Anordnung (1) nach einem der vorangehenden Ansprüche,
**dadurch gekennzeichnet, dass**
das lumineszierende Material der Wellenleiterschicht (13) eine Schichtdicke aufweist, bei der das Primärlicht nahezu vollständig absorbiert wird.

8. OLED-Wellenleiter-Anordnung (1) nach einem der vorangehenden Ansprüche,
**dadurch gekennzeichnet, dass**
das Wellenleiterschicht (13) und / oder Abstandsschicht (12) gebildet sind aus:
- (2-{(E)-2-[4-(Dimethylamino)phenyl]vinyl}-6-methyl-4H-pyran-4-yliden)malononitril zur Dotierung in Polyvinylcarbazol und /oder
- Tris-(4,7-diphenyl-1,10-phenanthropon)-ruthenium (II) Dichlorid in Polymethylmethacrylat und / oder
- Super Yellow als Polymer ohne separate Matrix.

9. OLED-Wellenleiter-Anordnungsherstellungsverfahren für eine OLED-Wellenleiter-Anordnung (1) nach einem der vorangehenden Ansprüche aufweisend die Schritte:
- Herstellen eines Substrats (14) mit einer pixelabhängigen Nanostruktur auf der Oberfläche
- im Spritzgussverfahren in Kunststoff
oder
- durch Aufbringen einer Photolackschicht auf dem Substrat (14) und Strukturierung mit Hilfe eines Nanoprägeverfahrens;
- Aufbringen einer Wellenleiterschicht enthaltend eine Photolumineszenzschicht durch Flüssigphasenbeschichtung oder Verdampfung oder Kathodenzerstäubung, wobei entweder ein Material beide Zwecke erfüllen kann oder zwei separate Materialien verwendet werden;
- Aufbringen einer Abstandsschicht (12), die die aktiven Schichten der organischen Leuchtdiodenanordnung (11) von dem nanostrukturierten Wellenleiter trennt;
- Prozessieren der organischen Leuchtdiodenanordnung (11) oberhalb der Abstandschicht (12) aus der Flüssigphase und/oder in einem Vakuumprozess,
wobei der Schritt des Prozessierens beinhaltet, dass eine untere Elektrode der organischen Leuchtdiodenanordnung (11) teiltransparent ausgelegt wird und auf die teiltransparente Elektrode organische Transport-, Block- und Emissionsschichten aufgebracht werden, wobei die organische Leuchtdiodenanordnung (11) mit einer zweiten Metallelektrode, die dicker und nichttransparent ausgebildet sein kann, abgeschlossen wird und wobei ein Versiegeln der Oberseite der organischen Leuchtdiodenanordnung, also der der Emission der Strahlung abgewandten Seite, mit einer Verkapselung aus Glas oder Kunststoff erfolgt.

## Claims

1. OLED waveguide assembly (1) comprising an organic light emitting diode assembly (11), a waveguide layer (13) and a substrate (14), wherein
- the organic light-emitting diode assembly (11) is separated from the waveguide layer by a spacer layer (12)
and
- the organic light-emitting diode assembly (11), the spacer layer (12), the waveguide layer (13) and the substrate (14) are materially interconnected in a layer stack and
- the emission of the organic light-emitting diode assembly (11) has maximum emission at a wavelength of around 470 nanometers,
**characterised in that**
- the waveguide layer (13) is nanostructured,
- the waveguide layer (13) and the spacer layer (12) are made of organic material
- the spacer layer (12) is designed to be transparent to the light from the organic light-emitting diode assembly (11) and the light from the waveguide layer (13),
- the organic light-emitting diode assembly (11) is designed as a primary light source,
- the substrate (14) has pixel-dependent nanostructures on its surface, namely nanostructures that are identical pixel by pixel or slightly different pixel by pixel, which are formed with a lattice constant of approximately 400 ± 50 nanometres to match the emissions of the waveguide layer (13),
- the spacer layer (12) has a layer thickness of 300 to 500 nanometres,
wherein
- the waveguide layer (13)
- itself consists of luminescent material
or
- has an upstream layer of luminescent material,
- the waveguide layer (13) or the upstream layer of the waveguide has the function of a wavelength converter with maximum absorption at around 470 nanometres and maximum emission at around 620 nanometres,
and
- the substrate (14) is at least the outer side of the arrangement on the light exit surface
or
- the substrate (14) is at least the outer side of the arrangement on the light exit surface, wherein an additional wavelength-selective (dichroic) layer and/or a long-pass filter is integrated into the layer stack on the light exit surface.

2. OLED waveguide assembly (1) according to claim 1,
**characterised in that**
the waveguide layer (13) is completely nanostructured.

3. OLED waveguide assembly (1) according to claim 1 or 2,
**characterised in that**
the waveguide layer (13) has the nanostructuring at least on the side facing the substrate (14).

4. OLED waveguide assembly (1) according to one of the preceding claims,
**characterised in that**
the nanostructures on the waveguide layer (13) are arranged pixel by pixel, wherein the nanostructures on the waveguide layer (13)
- are identical pixel by pixel
or
- are slightly different pixel by pixel.

5. OLED waveguide assembly (1) according to one of the preceding claims,
**characterised in that**
the refractive index of the waveguide layer (13) is higher than that of the substrate (14) and the spacer layer (12).

6. OLED waveguide assembly (1) according to one of the preceding claims,
**characterised in that**
the organic light-emitting diode assembly (11) is designed in the form of thin, partially transparent metal layers and/or conductive polymers and/or poly-3,4-ethylenedioxythiophene and/or polystyrene sulfonate with carbon nanotubes.

7. OLED waveguide assembly (1) according to one of the preceding claims,
**characterised in that**
the luminescent material of the waveguide layer (13) has a layer thickness at which the primary light is almost completely absorbed.

8. OLED waveguide assembly (1) according to one of the preceding claims,
**characterised in that**
the waveguide layer (13) and/or spacer layer (12) are formed from:
- (2-{(E)-2-[4-(dimethylamino)phenyl]vinyl}-6-methyl-4H-pyran-4-ylidene)malononitrile for doping in polyvinylcarbazole and/or
- tris-(4,7-diphenyl-1,10-phenanthropon)-ruthenium (II) dichloride in polymethyl methacrylate and/or
- Super Yellow as a polymer without a separate matrix.

9. OLED waveguide assembly manufacturing method for an OLED waveguide assembly (1) according to one of the preceding claims, comprising the steps:
- producing a substrate (14) with a pixel-dependent nanostructure on the surface
- by injection moulding in plastic
or
- by applying a photoresist layer to the substrate (14) and structuring it using a nanoimprinting process;
- applying a waveguide layer containing a photoluminescent layer by liquid phase coating or evaporation or cathode sputtering, wherein either one material can fulfil both purposes or two separate materials are used;
- applying a spacer layer (12) separating the active layers of the organic light-emitting diode assembly (11) from the nanostructured waveguide;
- processing the organic light-emitting diode assembly (11) above the spacer layer (12) from the liquid phase and/or in a vacuum process,
wherein the step of processing includes designing a lower electrode of the organic light-emitting diode assembly (11) to be partially transparent and to this partially transparent electrode there are applied organic transport, blocking and emission layers, wherein the organic light-emitting diode assembly (11) is closed with a second metal electrode, which can be thicker and non-transparent, and wherein the upper side of the organic light-emitting diode assembly, i.e. the side facing away from the emission of the radiation, is sealed with an encapsulation made of glass or plastic.

## Revendications

1. Ensemble de guide d'ondes OLED (1) comprenant un ensemble de diodes électroluminescentes organiques (11), une couche de guide d'ondes (13) et un substrat (14), dans lequel
- l'ensemble de diodes électroluminescentes organiques (11) est séparé de la couche de guide d'ondes par une couche d'espacement (12),
et
- l'ensemble de diodes électroluminescentes organiques (11), la couche d'écartement (12), la couche de guide d'ondes (13) et le substrat (14) sont reliés entre eux par matière dans un empilement de couches
et
- l'émission de l'ensemble de diodes électroluminescentes organiques (11) présente une émission maximale à une longueur d'onde d'environ 470 nanomètres,
**caractérisé en ce que**
- la couche de guide d'ondes (13) est nanostructurée,
- la couche de guide d'ondes (13) et la couche d'espacement (12) sont constituées de matériau organique,
- la couche d'espacement (12) est transparente à la lumière provenant de l'ensemble de diodes électroluminescentes organiques (11) et la lumière provenant de la couche de guidage d'ondes (13),
- l'ensemble de diodes électroluminescentes organiques (11) est conçu comme source de lumière primaire,
- le substrat (14) présente sur sa surface des nanostructures dépendantes des pixels, c'est-à-dire identiques pixel par pixel ou légèrement différentes pixel par pixel, qui sont conçues avec une constante de réseau d'environ 400 ± 50 nanomètres correspondant aux émissions de la couche de guide d'ondes (13),
- la couche d'espacement (12) présente une épaisseur de couche de 300 à 500 nanomètres,
où
- la couche de guide d'ondes (13)
- est elle-même constituée d'un matériau luminescent
ou
- comporte une couche en amont constituée d'un matériau luminescent,
- la couche de guidage d'ondes (13) ou la couche en amont du guide d'ondes a la fonction d'un convertisseur de longueur d'onde avec une absorption maximale autour de 470 nanomètres et une émission maximale autour de 620 nanomètres
et
- le substrat (14) est au moins la face extérieure de l'agencement sur la surface de sortie de la lumière
ou
- le substrat (14) est au moins la face extérieure de l'agencement sur la surface de sortie de la lumière, dans lequel une couche supplémentaire sélective en longueur d'onde (dichroïque) et/ou un filtre passe-bande long étant intégrés dans la pile de couches sur la surface de sortie de la lumière.

2. Ensemble de guide d'ondes OLED (1) selon la revendication 1,
**caractérisé en ce que**
la couche de guide d'ondes (13) est entièrement nanostructurée.

3. Ensemble de guide d'ondes OLED (1) selon la revendication 1 ou 2,
**caractérisé en ce que**
la couche de guide d'ondes (13) présente la nanostructuration au moins sur le côté tourné vers le substrat (14).

4. Ensemble de guide d'ondes OLED (1) selon l'une des revendications précédentes,
**caractérisé en ce que**
les nanostructures sont disposées pixel par pixel sur la couche de guide d'ondes (13), les nanostructures sur la couche de guide d'ondes (13) étant
- identiques pixel par pixel
ou
- légèrement différentes pixel par pixel.

5. Ensemble de guide d'ondes OLED (1) selon l'une des revendications précédentes,
**caractérisé en ce que**
l'indice de réfraction de la couche de guide d'ondes (13) est supérieur à celui du substrat (14) et de la couche d'espacement (12).

6. Ensemble de guide d'ondes OLED (1) selon l'une des revendications précédentes,
**caractérisé en ce que**
le dispositif à diodes électroluminescentes organiques (11) est constitué de fines couches métalliques partiellement transparentes et/ou de polymères conducteurs et/ou de poly-3,4-éthylènedioxythiophène et/ou de polystyrène sulfonate avec des nanotubes de carbone.

7. Ensemble de guide d'ondes OLED (1) selon l'une des revendications précédentes,
**caractérisé en ce que**
le matériau luminescent de la couche de guide d'ondes (13) présente une épaisseur de couche telle que la lumière primaire est presque entièrement absorbée.

8. Ensemble de guide d'ondes OLED (1) selon l'une des revendications précédentes,
**caractérisé en ce que**
la couche de guide d'ondes (13) et/ou la couche d'espacement (12) sont formées à partir de :
- (2-{(E)-2-[4-(diméthylamino)phényl]vinyl}-6-méthyl-4H-pyran-4-ylidène)malononitrile pour le dopage dans le polyvinylcarbazole et/ou
- du dichlorure de tris-(4,7-diphényl-1,10-phénanthropone)-ruthenium (II) dans du polyméthacrylate de méthyle et/ou
- du Super Yellow comme polymère sans matrice séparée.

9. Procédé de fabrication d'un ensemble de guide d'ondes OLED pour un dispositif à guide d'ondes OLED (1) selon l'une des revendications précédentes, comprenant les étapes suivantes :
- la fabrication d'un substrat (14) avec une nanostructure dépendante des pixels sur la surface
- par moulage par injection dans du plastique
ou
- par application d'une couche de photoréserve sur le substrat (14) et structuration à l'aide d'un procédé de nano-estampage ;
- application d'une couche de guide d'ondes contenant une couche photoluminescente par revêtement en phase liquide ou évaporation ou pulvérisation cathodique, soit un matériau pouvant remplir les deux fonctions, soit deux matériaux distincts étant utilisés ;
- application d'une couche d'espacement (12) qui sépare les couches actives de l'ensemble de diodes électroluminescentes organiques (11) du guide d'ondes nanostructuré ;
- traitement de l'ensemble de diodes électroluminescentes organiques (11) au-dessus de la couche d'espacement (12) à partir de la phase liquide et/ou dans un processus sous vide,
dans lequel l'étape de traitement comprenant la conception d'une électrode inférieure de l'ensemble de diodes électroluminescentes organiques (11) de manière semi-transparente et l'application de couches de transport, de blocage et d'émission organiques sont appliquées sur l'électrode partiellement transparente, l'ensemble de diodes électroluminescentes organiques (11) étant complété par une deuxième électrode métallique qui peut être plus épaisse et non transparente, et la face supérieure de l'ensemble de diodes électroluminescentes organiques, c'est-à-dire la face opposée à l'émission du rayonnement, étant scellée par un encapsulage en verre ou en plastique.
